Europäisches Patentamt

European Patent Office

Office européen des brevets

(11) Publication number: **0 357 013**
**A2**

## EUROPEAN PATENT APPLICATION

(21) Application number: 89115965.9

(51) Int. Cl.⁵: **G01R 33/06**

(22) Date of filing: 30.08.89

(30) Priority: 02.09.88 US 240767
27.12.88 US 290814

(43) Date of publication of application:
**07.03.90 Bulletin 90/10**

(84) Designated Contracting States:
**DE ES FR GB IT NL**

(71) Applicant: HONEYWELL INC.
Honeywell Plaza
Minneapolis Minnesota 55408(US)

(72) Inventor: Thompson, James E.
10836 N. 66th Street
Scottsdale AZ 85254(US)
Inventor: Shank, Richard J.
905 W. Westcott Drive
Phoenix AZ 85027(US)

(74) Representative: Herzbach, Dieter et al
Honeywell Europe S.A. Holding KG Patent-
und Lizenzabteilung Kaiserleistrasse 39
Postfach 10 08 65
D-6050 Offenbach am Main(DE)

(54) Magnetic field measuring circuit.

(57) A sensing circuit (41) that uses a Hall current to sense the magnetic field strength (B) from a means (D) producing a magnetic field. The magnetic producing means (D) is in operative contact with the Hall device (47) wherein a flux field is generated in the Hall device. The sensing circuit (41) operates to inject a current ($I_s$) in the Hall current axis to force the voltage differential across the Hall device to zero. The injected current is then converted to an output voltage by an operational amplifier circuit (57, 59) configuration such as the transresistance amplifier. The output voltage is then measured by a meter such as a voltmeter or the like.

*Fig. 3*

## MAGNETIC FIELD MEASURING CIRCUIT

### BACKGROUND OF THE INVENTION

#### 1. Field of the Invention:

The present invention relates to a circuit for measuring the magnetic field strength in a magnetic system according to the preamble of claim 1.

#### 2. Discussion of the Prior Art:

Flux measurement circuits to measure the magnetic field strength of a means producing a magnetic field, such as magnetic actuators and magnetic suspension systems, magnetic bearings, magnetic switching systems or the like, are well known in the art. Some prior art circuits use Hall devices to measure the magnetic flux produced by such magnetic field producing means.

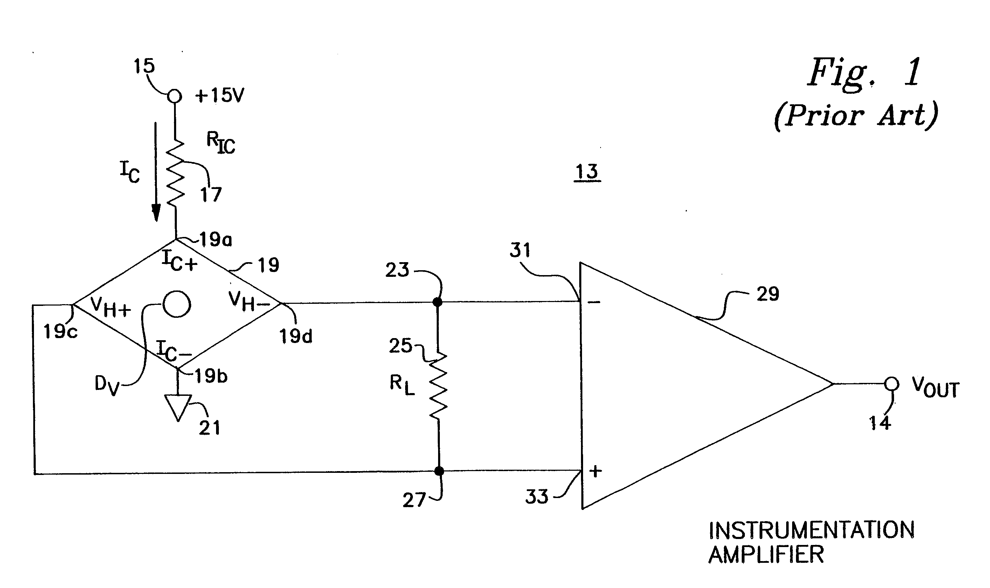

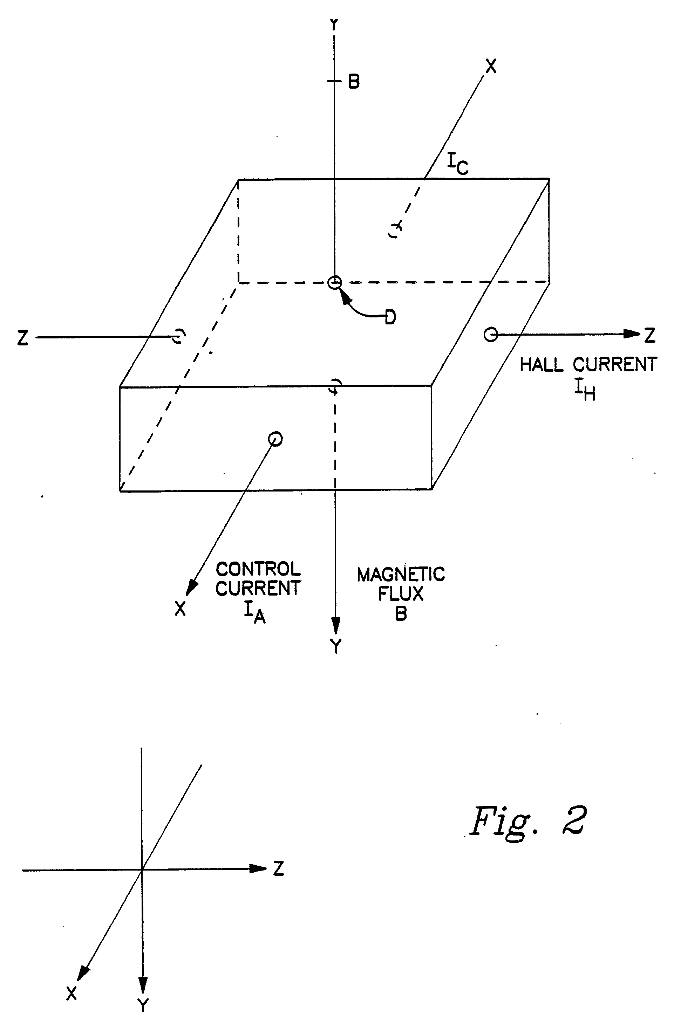

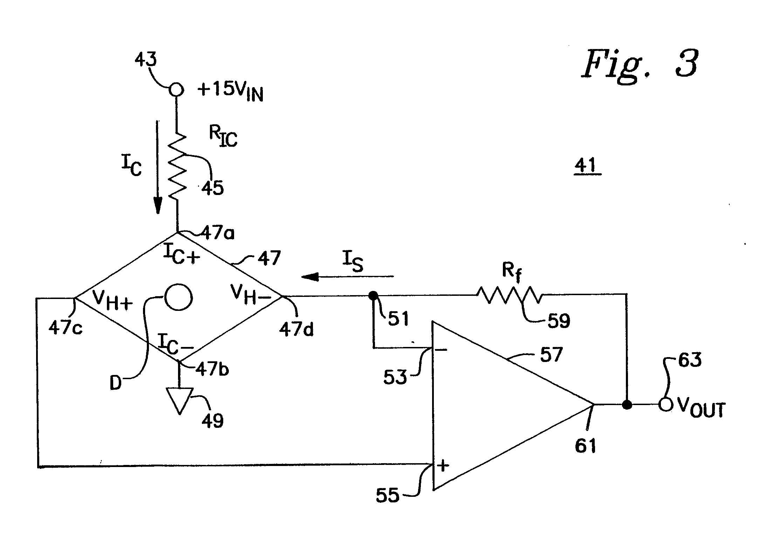

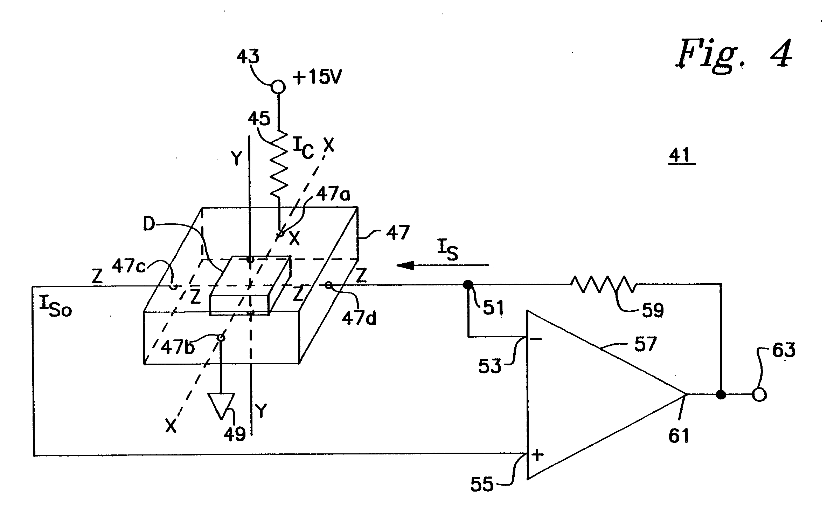

The classic method, using a Hall device for measuring the magnetic flux in a device producing a magnetic field, functions to impede the flow of a charge carrier in the circuit. Then by use of an instrumentation amplifier, the devices measure the Hall voltage $(V_h)$ developed due to the charge carrier bunching due to the impeded flow. A specific example is shown in the schematic wiring diagram of Figure 1. Referring to Figure 1, the circuit 13 includes a voltage source 15, resistor 17, Hall device 19, load resistor $(R_L)$ 25, instrumentation amplifier 29, and voltage output 14. The voltage output may be connected to a volt meter or the like. The Hall device 19 includes Hall contact $(I_c+)$19a, Hall contact $(I_c-)$19b, Hall contact $(V_h+)$-19c, and Hall contact $(V_h-)$19d. Current control resistor 17 is connected between power source 15 and contact 19a. Contact 19b is connected to ground 21. Resistor 25, or load resistor $R_L$, is connected between junctions 23 and 27. Load resistor 25 is used to maintain the voltage between junctions 23 and 27. The voltage drop across load resistor 25 is a function of the magnitude of the magnetic field strength induced by device $D_v$. The instrumentation amplifier 29 is connected to the circuit via pins 31 and 33. The resultant voltage $V_h$ ·is applied to instrumentation amplifier 29 and the amplified voltage is applied at output 14. Output 14 may be connected to a volt meter or the like.

In summary, the prior art Hall circuit shown in FIG. 1 and described herein above, operates to impede the flow of the charge carriers and then measures the Hall voltage, developed due to the bunching of the charges, by the use of an instrumen- tation amplifier 29. The Hall voltage for the Hall circuit illustrated in FIG. 1 is typically about 10 millivolts per kilo Gauss. This level of Hall voltage makes measurement of the magnetic field strength extremely difficult in the noisy environment of a switching magnetic field. Additionally, the control current $I_c$ for the prior art circuit described herein above is about 150 milliamps or about 2.25 watts from the 15 volt power supply 15, shown in FIG. 1. This results in high power requirements and power consumption on the part of the prior art circuit. Moreover, this increases the stress on the electrical components in the circuit which can ultimately lead to failure of these components in field operations.

It is, therefore, the object of the present invention to provide a unique Hall effect flux sensing circuit which has reduced power consumption, improved performance and effects flux sensing in a reliable manner.

This object is achieved according to the characterizing features of claim 1. Further advantageous embodiments of said circuit may be taken from the dependent claims.

### SUMMARY OF THE INVENTION

This unique invention is an improved sensor circuit that uses a Hall device to sense the magnetic field strength or flux of a system producing a magnetic field, when said magnetic producing system is in operative contact with the Hall device. The Hall flux sensing circuit injects a current $I_c$ at the Hall axis to force the voltage differential across the Hall device to zero. The injected current is then converted to an output voltage by an operational amplifier configuration, preferably a transresistance amplifier and a feedback circuit combination. The output voltage can then be sensed by a volt meter or the like. The use of a Hall current as opposed to a Hall voltage effectively linearizes the current by eliminating the non-linear effects of the carrier bunching. Further, the unique device improves the noise immunity by measuring the current $I_c$ instead of the voltage $V_H$ as is measured in the prior art device. Hall currents are on the order of about 1 milliamp per kilogauss with a control current of about 10 milliamps.

The control current may be reduced to about 5 milliamps. This translates to a reduction of power consumption by about 30 times when compared with the prior art device of Figure 1. This power reduction results in less complicated circuitry to supply the control current and less complex and costly components. The use of the transresistance amplifier also results in a cost savings over the instrumentation amplifier of FIG. 1. The use of the lower control current permits the use of an operational amplifier such as a transresistance amplifier without any additional transistor circuitry.

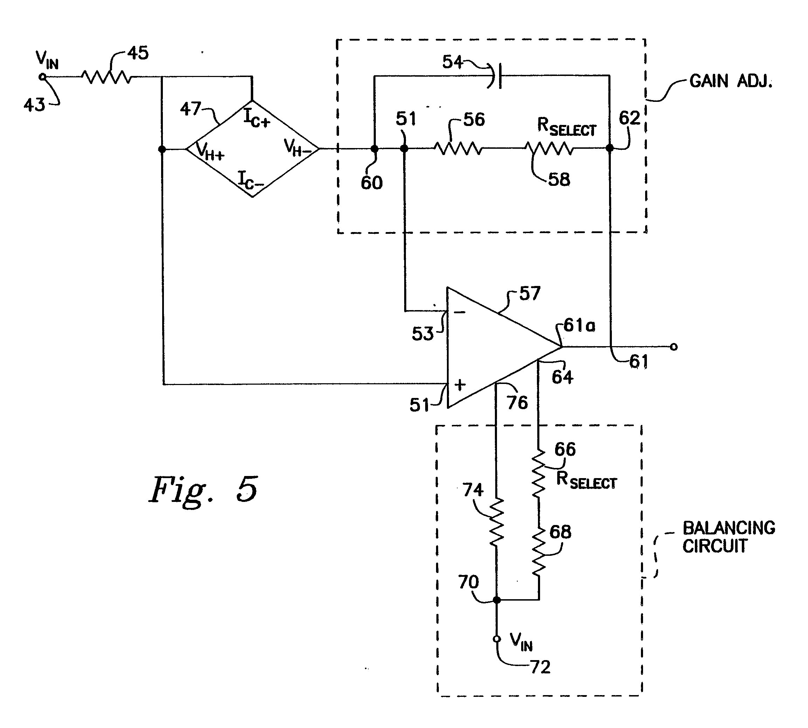

There are advantages, objects and features of novelty which characterize the unique invention disclosed herein and are pointed out with particularity in the claims annexed hereto and forming a part hereof. However, for a better understanding of the invention, its advantages, and objectives attained by its use, reference should be had to the drawings, particularly to FIGS. 3 - 6, which form a part hereof, and its accompanying descriptive subject matter in which there is illustrated and described a preferred embodiment of the present invention.

## BRIEF DESCRIPTION OF THE DRAWINGS

FIG. 1 is a wiring schematic showing the "PRIOR ART" circuit using a Hall device to measure the magnetic flux of a device generating a magnetic field.

FIG. 2 is an isometric view of a typical Hall device and the electrical/magnetic relationship between the control current $(1_c)$ applied at the X axis, the flux (B) applied at the Y axis, and the Hall current $I_h$ generated at the Z axis of said device.

FIG. 3 is a wiring schematic showing the unique Hall current injection circuit for sensing the magnetic field strength in a device producing a magnetic field which is the preferred embodiment of the present invention.

FIG. 4 is a schematic wiring diagram of the Hall injection magnetic flux sensing circuit with pictorial projection of the Hall device, shown isometrically in FIG. 2 and symbolically in FIG. 3, connected in the unique circuit with the magnetic flux generating device in operative proximity of the Hall device.

FIG. 5 is a wiring schematic of the Hall current injection circuit with special circuitry for frequency compensation in the circuit.

FIG. 6 is a wiring schematic of the Hall current injection circuit including a specific circuit for producing a temperature compensated control current.

FIG. 7 is a wiring schematic of the Hall current injection device including specialized circuitry for frequency compensation.

## DESCRIPTION OF THE PREFERRED EMBODIMENT

To understand the function and use of a Hall sensor to measure the field strength in any device generating a magnetic field, a brief description of a Hall device shown in FIG. 2, is provided. Referring now to FIG. 2, the Hall device 11 shown is made from a block of relatively pure semiconductor material comprising three (3) axes; namely X, Y and Z respectively. In normal operation, a flux sensing current, or a control current $I_c$, is applied at the X axis of the device 11. A magnetic flux B is applied at the Y axis. The flux B is generated by a device D, generating a magnetic flux. This device may be mounted directly beside the Hall device 11 for a maximum flux generation. The device D is normally positioned in the operative proximity of the Y axis during operation. The magnetic field is then a function of flux B. The Hall current $I_h$ is then generated at the Z axis. The device disclosed and used as example in the present invention is a BH-200 supplied by F. W. Bell of Orlando, Florida. Other similar devices may be used by those skilled in the art without deviating from the scope and content of the present invention disclosed and claimed herein.

Briefly in summary, if a control current $I_c$ is injected into device 11, and device 11 is also exposed to magnetic field H, at the Y axis, from devices like a magnetic actuator from a magnetic suspension system, magnetic bearings or a magnetic switching circuitry, or the like. The resultant is a migration of the charge carrier Hall current in the Z axis.

With this as background, the unique embodiment of the present invention will be disclosed in connection with FIG. 3 and FIG. 4. Briefly. FIG. 4 shows pictorially the Hall device 47, (represented as an electrical symbol in FIG. 3) in operative association with a pictorial representation of a means for producing a magnetic flux D. As stated before, means D may be a magnetic actuator, a magnetic switching system or similar such means. FIG. 4 is now provided in addition to FIG. 3 to describe the details of the operation of the Hall device illustrated in FIG. 2, in operation in the unique Hall flux sensing circuit 41, shown in FIGS. 3 and 4. Referring now to FIGS. 3 and 4 the Hall current injection circuit 41, for sensing the magnetic flux B, from a means generating a magnetic field D, is comprised of a power source 43, resistance 45, Hall device 47, operational amplifier 57, feedback resistor 59, and voltage output $(V_{out})$ 63. Resistance 45 is generally a large resistor to generate a $I_c R_{ic}$ voltage drop across resistor 45. The Hall device 47, includes Hall contacts $(I_c +)$ 47a, Hall contact $(I_c -)$ 47b, Hall contact $(V_h +)$ 47c, and Hall contact $(V_h +)$ 47d. The voltage source 43 is preferably a 15 volt power supply or an equivalent. Resistor $(R_{ic})$ 45 is connected between power source 43, and Hall contact $(I_c +)$ 47a. Hall contact

($I_c$-) 47b, is connected to ground 49. Feedback resistor 59 is connected between junctions 51 and 61. Pin 53 of operational amplifier 57 is connected in the circuit by pin 51. Pin 55 is connected to the output of the Hall contact ($V_h$+) 47c. Junction 61 is connected between ($V_{out}$) 63 and the output of operational amplifier 57. The function of feedback resistor 59 as part of the feedback circuit connected operational amplifier 57 will be explained in detail in connection with the detailed description of the operational amplifier herein below.

Referring to FIG. 4, the magnetic device D may be a magnetic actuator, magnetic bearings, magnetic switching systems or equivalent device. The magnetic device D is placed in operational proximity to the Y axis of the Hall device 47. This generates a magnetic flux B in the Hall device.

Referring again to FIG. 4 the unique current injection circuit 41 operates as follows.

FIG. 4 shows the injection current $I_s$, which is injected into the Z axis of the Hall device 47. When sufficient current $I_s$ is injected in the Z axis of Hall device 47, the voltage differential across the Hall device 47 is driven to zero. The resultant voltage at the input to the operational amplifier 57 will also be at zero. The injected current $I_s$ which flows into transresistance amplifier 57 is connected to feedback resistor 59, which resistor sets the transresistance gain of amplifier 57. The output voltage $V_o$ at junction 61 is equal to the injected current $I_s$ times the resistance of feedback resistor 59. This output voltage can be measured by a voltmeter, or the equivalent at output 63. This type current amplification device is well known in the art. In summary, Hall circuit 41 measures the injected Hall current $I_s$ as opposed to Hall voltage $V_h$. The amplifier 57 measures the injected current $I_s$ as a function of a magnetic flux. The transresistance amplifier converts the injected Hall current $I_s$ to an output voltage at 61. Feedback resistor 59 is located between junction 61 and pin 53 of operational amplifier 57, and functions to provide feedback current flow to the amplifier 57.

Due to the unconventional use of the Hall device 47, the Hall injection current or output current $I_s$ versus $I_c$ and flux B, needs to be considered and discussed. The equation defining the operation of the circuit shown in FIG. 3, is as follows:

$I_s = Khi \cdot I_c \cdot B$

Khi is the empirically determined current mode Hall constant. Khi is typically about .1/amp K gauss for the BH-200 Hall device. This shows that $I_s$ is a function of both $I_c$, and B and varies depending on the magnitude of either $I_c$, or B or both.

Referring now to FIGS. 5, 6 and 7, it has been found that like all flux measurement devices, including unique current injection Hall sensing circuit 41, is susceptible to the usual anomalies due to current variations, temperature and frequency variations and the like. Additionally, the offset voltage in the unique circuit, due to the characteristics of the particular operational amplifier used in the circuit causes the degradation in the operation of circuit 41. Additionally the misalignment of the Hall contacts $V_h$+ and $V_h$- in the Hall device requires specific adjustments to the circuit. The offset voltage anomalies and the misalignment may be adjusted by a conventional balancing circuitry well known in the art which circuitry will be described herein. A typical current balancing circuit is shown in FIG. 5. Referring now to detail in schematic wiring diagram in FIG. 5, the offset voltages due to operational amplifier 57 characteristics and the misalignment of the Hall carrier contacts frequently require adjustment. The balancing circuit comprises R select resistor 66, resistance 68, a power supply 72 and resistor 74. This adjustment can be controlled by R select resistor 66 in the calibration circuitry located between pins 76 and 64 connected to amplifier 57.

Impurities and process variations in the semiconductor material that comprises the Hall device can also cause the current mode Hall constant (Khi) to vary. Generally this variance can be adjusted by the gain adjusting select resistor 58, in gain circuit shown in FIG. 5. Specifically resistor 58 should be selected for zero Hall injection current $I_s$ or zero volts from pin 51 to pin 53 of operational amplifier 57, in any 0 gauss field. Due to semiconductor impurities and process variations, the current mode Hall constant (Khi) discussed above can vary from device to device. This adjustment may be accomplished by a low-pass filter circuit included in the device. The circuit includes a resistor 56, R select resistor 58, and capacitor 54. Resistors 56 and 58 are connected between junctions 51, 60 and 62 respectively. The offset voltage due to the misalignment of the Hall contacts are corrected with R select resistor 66 and connected to pin 64 of the operational amplifier 57.

Variations of the type mentioned herein are corrected with this gain circuit with the gain adjusting select resistor 58, connected pin 62 of the operational amplifier 57. This resistor 58 can also be used to compensate for minor temperature variations. The gain adjustment should be performed preferably at about 25˚ Centigrade, plus or minus 2˚ Centigrade. It should be noted that this circuitry described herein is conventional circuitry known in the art and that the gain and balancing circuitry shown are merely exemplary of a typical circuitry for balancing and adjusting the sensing.

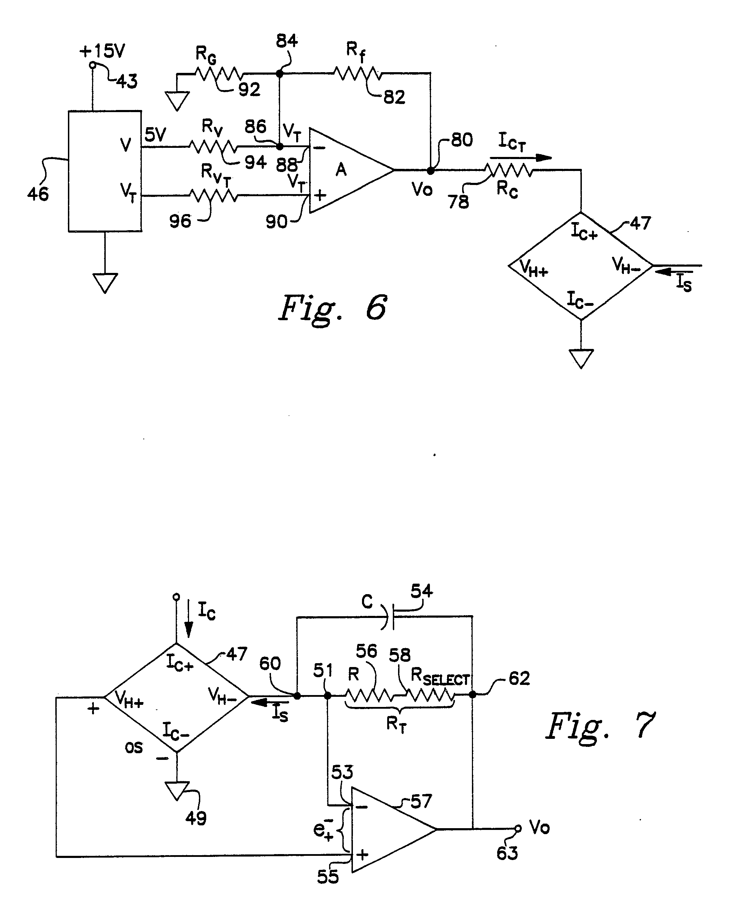

Referring now directly to FIG. 6, buffering the temperature output from reference voltage 46, with proper gain adjustment to resistor 92, can produce a temperature compensation control source for Hall device 41. For example the buffering circuit shown in FIG. 6 includes reference voltage source 46 with outputs V and $V_t$ connected to resistor ($R_v$) 94, and resistor ($R_{vt}$) 96 connected to amplifier A via pins 86 and 92. Feedback resistor ($R_f$) 82 is connected between junctions 84 and 80. Buffering the temperature output from a low voltage reference device 46 is accomplished by selecting the proper gain resistor ($R_g$) 92 in the circuit shown in FIG. 6. The magnitude of the gain resistor ($R_g$) 92 is a function of the temperature. Therefore by varying the current I with the temperature creates a voltage that varies with the ambient temperature and produces a constant control current $I_c$, buffered or adjusted for temperature. As resistor $R_G$ is adjusted, resistors $R_c$, $R_v$ and $R_{vt}$ essentially control amplifier A to operate as a buffer circuit. To control temperature this circuit configuration is a standard buffer circuit well known in the art.

Referring now to FIG. 7, the Hall flux sensor circuit 41 can also be frequency compensated with various techniques well known in the art. One specific technique is illustrated in FIG. 7. Hall device 47 and operational amplifier 57 are connected to a low-pass filter circuit which circuit includes resistor 56, resistor select 58 and capacitor 54 connected between junctions 60 and 62. The low-pass filter functions to limit the frequency and compensate for any frequency variations in the circuit 41. The temperature output of the reference voltage from reference voltage 46 produces a temperature compensated control current $I_c$ for Hall device 17. The current injection Hall sensing circuit can also be frequency compensated. This can be accomplished by the frequency control circuit shown in FIG. 7. By selecting the appropriate resistance for (R select) 58. This circuit is essentially a low-pass filter with a preset break point that sets an operational frequency for the current injection Hall sensing circuit. Frequency compensation circuitry is well known. Other equivalent frequency compensation circuitry may be used and is within the scope and content of the present invention.

Numerous characteristics and advantages of the present invention have been set forth in the foregoing description, together with details of the structure and function of the unique Hall sensor circuitry 41, and the novel features are pointed out in the appended claims. The disclosure, however, is illustrative only, and changes may be made in detail, especially in matters of specific circuit design, size and arrangement or use of the equivalent components within the principle of the invention to the full extent indicated by the broad general terms in which the impending claims are expressed.

**Claims**

1. A circuit for measuring the magnetic field strength in a magnetic system, **characterized by:**
   a) a means (43, 45, 49, 57, 59) for injecting a current ($I_s$) in the Hall current axis of a Hall device (47);
   b) said magnetic system (D) connected to said Hall device (47) to generate a magnetic field;
   c) said Hall device generating an output current ($I_H$) as a function of said magnetic field; and
   d) a measuring means (41) connected to the output of said Hall device to measure the output current.

2. Circuit according to claim 1, **characterized in that** said current output is a function of the generated magnetic field.

3. Circuit according to claim 1 **characterized in that** said injection current ($I_s$) is applied to said Hall device (47) to force the voltage differential across said Hall device to zero.

4. Circuit according to claim 3, **characterized in that** said injection current ($I_s$) is a function of a control current ($I_c$) and the magnetic flux (B) of said device (D) generating a magnetic field.

5. Circuit according to claim 3, **characterized in that** the Hall sensing means (41) measures said injected current ($I_s$) as a function of the magnetic field.

6. Circuit according to claim 5, **characterized in that** said sensing means (41) converts the injection current ($I_s$) to an output voltage ($V_{out}$).

7. Circuit according to claim 6, **characterized in that** said sensing means is an operational amplifier (57).

8. Circuit according to claim 7, **characterized in that** said operational amplifier (57) is a transresistance amplifier.

9. Circuit according to claim 1, **characterized in that** said circuit includes a means (45) for limiting the control current ($I_c$).

10. Circuit according to claim 1, **characterized in that** the circuit includes a means (82 - 92) for compensating for the temperature in the circuit.

11. Circuit according to claim 1, **characterized in that** said circuit further includes a means (54) to compensate for frequency variations.

Fig. 1
(Prior Art)

INSTRUMENTATION AMPLIFIER

Honeywell

Fig. 2

Fig. 3

EP 0 357 013 A2

*Fig. 4*

EP 0 357 013 A2

Fig. 5

GAIN ADJ.

BALANCING CIRCUIT

$V_{IN}$ 43

45

47 $I_{C+}$ $V_{H-}$ $I_{C-}$ $V_{H+}$

54

56

$R_{SELECT}$ 58

62

60

51

57

53 − 51 +

61a

61

64

76

66 $R_{SELECT}$ 68

74

70

$V_{IN}$ 72

*Fig. 6*

*Fig. 7*

Honeywell